# EUROPEAN PATENT APPLICATION

(11) **EP 4 120 497 A1**
(43) Date of publication of application: **18.01.2023**
(21) Application number: 21767491.0
(22) Date of filing: 03.02.2021
(51) Int. Cl.: H02H 7/20

(54) **PROTECTION APPARATUS AND METHOD FOR INSULATED GATE BIPOLAR TRANSISTOR**

(30) Priority: 13.03.2020 CN 202010174600
(71) Applicant: OMRON Corporation, Kyoto-shi, Kyoto 600-8530 (JP)
(72) Inventor: LIU, Jie, Shanghai 200120 (CN)
(74) Representative: HGF
(86) International application number: PCT/CN2021/074971
(87) International publication number: WO 2021/179858

(57) **Abstract**

The embodiments of the present disclosure provide a protection apparatus and method for an insulated gate bipolar transistor. The protection apparatus includes: a collection circuit, configured to collect a driving signal of an IGBT, perform delay processing in a case where the driving signal is a first level for switching on the IGBT or is a first level that is converted from a second level for switching off the IGBT and is used for switching on the IGBT, and output a first signal according to a signal after the delay processing and the driving signal; a detection circuit, configured to detect a voltage between a collector electrode and an emitter electrode of the IGBT, and output a second signal according to the voltage and a preset threshold value; and a determination circuit, configured to output an alarm signal or a protection signal in a case where both the first signal and the second signal are valid. Thereby, delay processing is performed with a simple structure without affecting driving signals, the performance of an IGBT is improved, the cost for circuit protection is reduced, and easy adjustment of the control on the IGBT is improved.

## Description

### TECHNICAL FIELD

The embodiments of the present disclosure relate to the technical field of semiconductors, in particular to a protection apparatus and method for an insulated gate bipolar transistor (IGBT).

### BACKGROUND

The IGBT has been widely applied in power electronics, however in the absence of a suitable protection circuit, the IGBT is easily damaged, overcurrent and short circuit (for example, upper and lower bridge arms are directly connected in an inverted loop), etc. are common reasons for causing IGBT damages.

Currently, there are already some protection circuits for the IGBT. For example, in the reference literature 1, a double protection mechanism, i.e., interlocking and delaying, on a hardware is proposed, which avoids a situation in which upper and lower bridge arms are directly connected in the IGBT.

Reference literature 1: CN106385009A.

It should be noted that the above introduction to the Background is just to facilitate a clear and complete description of the technical solution of the present disclosure, and is elaborated to facilitate the understanding of persons skilled in the art. It cannot be considered that the above technical solutions are known by persons skilled in the art just because these solutions are elaborated in the BACKGROUND of the present disclosure.

### SUMMARY

However, the inventor finds: in prior arts including the reference literature 1, interference filtering and shaping need to be performed on a driving signal of the IGBT, then hardware interlock and delay processing is performed, which not only affects the driving signal, but also needs two sets of shaping and delay processing circuits, the performance of the IGBT is reduced and the cost of the protection circuit is increased; moreover, a delay processing time is fixed and relatively long, which is not convenient to regulate control of the IGBT.

In order to solve at least one of said technical problems, the embodiments of the present disclosure provide a protection apparatus and method for an insulated gate bipolar transistor (IGBT), it is expected to improve the performance of the IGBT and to reduce the cost of the protection circuit; moreover, easy adjustment of the control on the IGBT is improved.

According to an aspect of the embodiments of the present disclosure, a protection apparatus for an insulated gate bipolar transistor is provided and includes:
a collection circuit, configured to collect a driving signal of an insulated gate bipolar transistor, perform delay processing in a case where the driving signal is a first level for switching on the insulated gate bipolar transistor or is a first level that is converted from a second level for switching off the insulated gate bipolar transistor and is used for switching on the insulated gate bipolar transistor, and output a first signal according to a signal after the delay processing and the driving signal;
a detection circuit, configured to detect a voltage (V_{CE}) between a collector electrode and an emitter electrode of the insulated gate bipolar transistor, and output a second signal according to the voltage and a preset threshold value; and
a determination circuit, configured to determine the insulated gate bipolar transistor is abnormal and output an alarm signal or a protection signal in a case where both the first signal and the second signal are valid, and determine the insulated gate bipolar transistor is normal in a case where at least one of the first signal and the second signal is invalid.

Thereby, the delay processing is performed according to a level of the driving signal of the IGBT, the first signal is outputted according to a signal after the delay processing and the driving signal, and the second signal is outputted according to the V_{CE} of the IGBT and the preset threshold value, the alarm signal or the protection signal is outputted in a case where both the first signal and the second signal are valid, the delay processing is performed with a simple structure to realize overcurrent protection and/or short circuit protection, the driving signal will not be affected. In addition, the performance of the IGBT is improved and the cost of the protection circuit is reduced, and easy adjustment of the control on the IGBT is improved.

In some embodiments, the collection circuit is configured to not perform the delay processing in a case where the driving signal is a second level for switching off the insulated gate bipolar transistor or is a second level that is converted from the first level for switching on the insulated gate bipolar transistor and is used for switching off the insulated gate bipolar transistor.

Thereby, the delay processing is performed according to the level of the driving signal only in some cases, the delay processing is not performed in other cases, which realizes low delay of IGBT control and further improves the performance of the IGBT and easy adjustment of the control on the IGBT.

In some embodiments, the first level for switching on the insulated gate bipolar transistor is a high level, the second level for switching off the insulated gate bipolar transistor is a low level.

Thereby, the driving signal is collected according to high and low levels of the driving signal, the delay processing is performed in case of a high level and is not performed in case of a low level, which further improves the performance of the IGBT and reduces the cost of the protection circuit, and improves easy adjustment of the control on the IGBT.

In some embodiments, the detection circuit is configured to output the second signal of the high level in a case where the voltage is greater than the preset threshold value and a bootstrap power supply of the insulated gate bipolar transistor is normal; the detection circuit is configured to output the second signal of the low level in a case where the voltage is smaller or equal to the preset threshold value, or the bootstrap power supply of the insulated gate bipolar transistor is turned off, or the bootstrap power supply of the insulated gate bipolar transistor is turned on but is abnormal;
the determination circuit is configured to determine the first signal is valid in a case where the first signal is a high level, and determine the second signal is valid in a case where the second signal is a high level.

Thereby, the second signal representing a state of the IGBT is outputted with a simple structure, and whether the IGBT is abnormal may be determined with a simple structure.

In some embodiments, the first level for switching on the insulated gate bipolar transistor is a low level, the second level for switching off the insulated gate bipolar transistor is a high level.

Thereby, the driving signal is collected according to high and low levels of the driving signal, the delay processing is performed in case of a low level and is not performed in case of a high level, which further improves the performance of the IGBT and reduces the cost of the protection circuit, and improves easy adjustment of the control on the IGBT.

In some embodiments, the detection circuit is configured to output the second signal of the low level in a case where the voltage is greater than the preset threshold value and a bootstrap power supply of the insulated gate bipolar transistor is normal; the detection circuit is configured to output the second signal of the high level in a case where the voltage is smaller or equal to the preset threshold value, or the bootstrap power supply of the insulated gate bipolar transistor is turned off, or the bootstrap power supply of the insulated gate bipolar transistor is turned on but is abnormal;
the determination circuit is configured to determine the first signal is valid in a case where the first signal is a low level, and determine the second signal is valid in a case where the second signal is a low level.

Thereby, the second signal representing a state of the IGBT is outputted with a simple structure, and whether the IGBT is abnormal may be determined with a simple structure.

In some embodiments, a driving power supply of the insulated gate bipolar transistor is different from a detection power supply of the protection apparatus and is isolated according to safety regulations.

Thereby, a power supply is independently configured for the IGBT and the protection circuit, flexibility in product type selection is improved.

In some embodiments, the insulated gate bipolar transistor is configured in an intelligent power module, the intelligent power module includes one or more insulated gate bipolar transistors, the one or more insulated gate bipolar transistors is/are respectively configured with the protection apparatus.

Thereby, the protection circuit(s) is/are independently configured for one or more IGBTs, flexibility in product type selection is improved.

In some embodiments, the intelligent power module includes an upper bridge circuit, including three insulated gate bipolar transistors, and the three insulated gate bipolar transistors are respectively configured with the protection apparatus;
the three insulated gate bipolar transistors respectively have different bootstrap power supplies, and driving power supplies of the three insulated gate bipolar transistors are different from the detection power supply of the protection apparatus and are isolated according to safety regulations.

Thereby, not only the protection circuit is independently configured for the upper bridge circuit, flexibility in product type selection is improved; but also the power supply of the protection circuit and the power supplies of three IGBTs of the upper bridge circuit are isolated respectively according to safety regulations and are not affected by common grounding of three driving signals, which further increase reliability.

According to another aspect of the embodiments of the present disclosure, a protection method for an insulated gate bipolar transistor is provided and includes:
collecting a driving signal of an insulated gate bipolar transistor, performing delay processing in a case where the driving signal is a first level for switching on the insulated gate bipolar transistor or is a first level that is converted from a second level for switching off the insulated gate bipolar transistor and is used for switching on the insulated gate bipolar transistor, and outputting a first signal according to a signal after the delay processing and the driving signal;
detecting a voltage between a collector electrode and an emitter electrode of the insulated gate bipolar transistor, and outputting a second signal according to the voltage and a preset threshold value; and
determining the insulated gate bipolar transistor is abnormal and outputs an alarm signal or a protection signal in a case where both the first signal and the second signal are valid, and determining the insulated gate bipolar transistor is normal in a case where at least one of the first signal and the second signal is invalid.

One of the advantageous effects of the embodiments of the present disclosure is: the delay processing is performed according to a level of the driving signal of the IGBT, the first signal is outputted according to a signal after the delay processing and the driving signal, and the second signal is outputted according to the VCE of the IGBT and the preset threshold value, the alarm signal or the protection signal is outputted in a case where both the first signal and the second signal are valid, the delay processing is performed with a simple structure to realize overcurrent protection and/or short circuit protection, the driving signal will not be affected. In addition, the performance of the IGBT is improved and the cost of the protection circuit is reduced, and easy adjustment of the control on the IGBT is improved.

Referring to the later description and figures, specific implementations of the present disclosure are disclosed in detail, indicating a manner that the principle of the present disclosure can be adopted. It should be understood that the implementations of the present disclosure are not limited in terms of the scope. Within the scope of the spirit and terms of the appended claims, the implementations of the present disclosure include many changes, modifications and equivalents.

### DESCRIPTION OF FIGURES

The included figures are used to provide a further understanding on the embodiments of the present disclosure, constitute a part of the Description, are used to illustrate the implementations of the present disclosure, and expound the principle of the present disclosure together with the text description. Obviously, the figures in the following description are only some embodiments of the present disclosure. Persons skilled in the art can also obtain other figures based on these figures under the premise that they do not pay inventive labor. In the figures:
FIG. 1 is a schematic diagram of a protection apparatus for the IGBT in the embodiments of the present disclosure;
FIG. 2 is a schematic diagram of a protection apparatus, a control apparatus and an IPM in the embodiments of the present disclosure;
FIG. 3 is an example diagram of a protection apparatus for the IGBT in the embodiments of the present disclosure;
FIG. 4 is another example diagram of a protection apparatus for the IGBT in the embodiments of the present disclosure;
FIG. 5 is a schematic diagram of a protection method for the IGBT in the embodiments of the present disclosure.

### DETAIL DESCRIPTION

Referring to the figures, through the following Description, the above and other features of the present disclosure will become obvious. The Description and figures specifically disclose particular implementations of the present disclosure, showing partial implementations which can adopt the principle of the present disclosure. It should be understood that the present disclosure is not limited to the described implementations, on the contrary, the present disclosure include all the modifications, variations and equivalents falling within the scope of the attached claims.

In the embodiments of the present disclosure, the term "first" and "second", etc. are used to distinguish different elements in terms of appellation, but do not represent a spatial arrangement or time sequence, etc. of these elements, and these elements should not be limited by these terms. The term "and/or" includes any and all combinations of one or more of the associated listed terms. The terms "include", "comprise" and "have", etc. refer to the presence of stated features, elements, members or components, but do not preclude the presence or addition of one or more other features, elements, members or components.

In the embodiments of the present disclosure, the singular forms "a/an" and "the", etc. include plural forms, and should be understood broadly as "a kind of' or "a type of', but are not defined as the meaning of "one"; in addition, the term "the" should be understood to include both the singular forms and the plural forms, unless the context clearly indicates otherwise. In addition, the term "according to" should be understood as "at least partially according to......", the term "based on" should be understood as "at least partially based on......", unless the context clearly indicates otherwise.

Features that are described and/or shown with respect to one implementation can be used in the same way or in a similar way in one or more other implementations, can be combined with or replace features in the other implementations. It should be emphasized that the term "comprise/include" when being used herein refers to the presence of a feature, a whole piece, a step or a component, but does not exclude the presence or addition of one or more other features, whole pieces, steps or components.

Implementations of the present disclosure will be described below with reference to the figures. The protection apparatus in the embodiments of the present disclosure can serve as a separate product or component to cooperate with the IGBT; or can be integrated with the IGBT to serve as a product or component; or can be integrated into an Intelligent Power Module (IPM) containing the IGBT, the present disclosure is not limited to these.

### EMBODIMENTS OF THE FIRST ASPECT

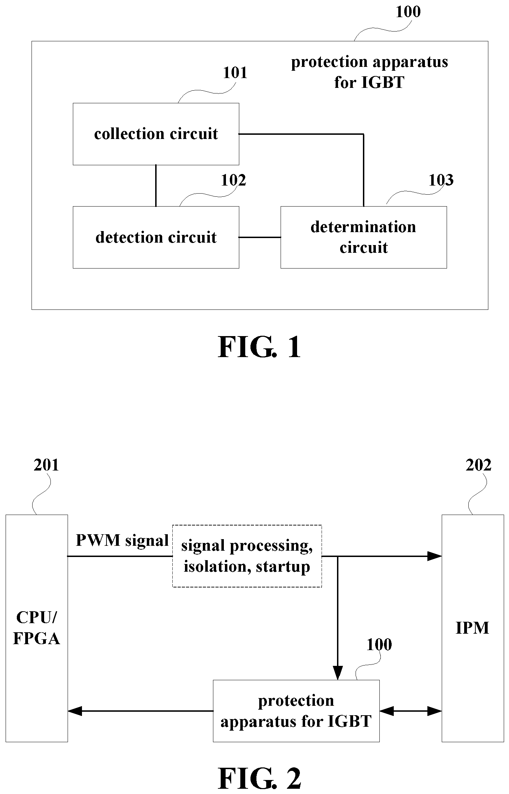

The embodiments of the present disclosure provide a protection apparatus for an IGBT. FIG. 1 is a schematic diagram of the protection apparatus for the IGBT in the embodiments of the present disclosure, as shown in FIG. 1, the protection apparatus 100 for the IGBT includes:
a collection circuit 100, configured to collect a driving signal of the IGBT, perform delay processing in a case where the driving signal is a first level for switching on (ON) the IGBT or is a first level that is converted from a second level for switching off (OFF) the IGBT and is used for switching on the IGBT, and output a first signal according to a signal after the delay processing and the driving signal;
a detection circuit 102, configured to detect a voltage (V_{CE}) between a collector electrode and an emitter electrode of the IGBT, and output a second signal according to the voltage and a preset threshold value; and
a determination circuit 103, configured to determine the insulated gate bipolar transistor is abnormal and outputs an alarm signal or a protection signal in a case where both the first signal and the second signal are valid, and determine the insulated gate bipolar transistor is normal in a case where at least one of the first signal and the second signal is invalid.

In some embodiments, the driving signal of the IGBT e.g. may be a Pulse Width Modulation (PWM) signal, the PWM signal switches on (ON) the IGBT in case of a high level and switches off the IGBT in case of a low level; however the present disclosure is not limited to this, for example it further may be other driving signal.

In some embodiments, the driving signal of the IGBT is outputted from a control apparatus such as a Central Process Unit (CPU) or a Field-Programmable Gate Array (FPGA) to an Intelligent Power Module (IPM) including the IGBT, however the present disclosure is not limited to this.

FIG. 2 is a schematic diagram of a protection apparatus, a control apparatus and an IPM in the embodiments of the present disclosure, as shown in FIG. 2, a CPU/FPGA 201 outputs the PWM signal which controls the IGBT in an IPM 202. As shown in FIG. 2, the protection apparatus 100 for the IGBT collects the PWM signal. For example, delay processing is performed if the PWM signal is a high level or is converted from a low level to a high level, a first signal is generated after AND gate processing is performed for a signal after the delay processing and the PWM signal.

As shown in FIG. 2, the protection apparatus 100 for the IGBT also collects a voltage V_{CE} of the IGBT in the IPM 202. For example, a high level is outputted in a case where the V_{CE} is greater than a preset threshold value and a bootstrap power supply of the IGBT is normal; a low level is outputted in a case where the V_{CE} is smaller or equal to the preset threshold value, or the bootstrap power supply of the IGBT is turned off, or the bootstrap power supply of the IGBT is turned on but is abnormal, thereby a second signal is generated.

For example, the protection apparatus 100 for the IGBT determines the first signal and the second signal of the high level to be valid. In a case where both the first signal and the second signal are valid, the protection apparatus 100 for the IGBT determines the IGBT in the IPM 202 runs abnormally, thereby an alarm signal or a protection signal is outputted to the CPU/FPGA 201, or also is outputted directly to the IPM 202. In a case where the first signal and/or the second signal are/is invalid, the protection apparatus 100 for the IGBT determines the IGBT in the IPM 202 is normal, an alarm signal or a protection signal is not outputted.

In the embodiments of the present disclosure, abnormal running of the IGBT is understood as resulting in possible destroy or damage to the IGBT, such as a situation including overcurrent and/or short circuit. A situation in which the power supply of the IGBT is turned off or the bootstrap power supply of the IGBT is turned on but is abnormal (such as a low voltage) can be detected and protected in other circuits or components. In the embodiments of the present disclosure, these situations will not destroy or damage to the IGBT, thus these situations are considered as normal situations.

As shown in FIG. 2, signal processing, signal isolation, etc. (optionally) are further performed for the PWM signal; this structure is applied to a servo driver; the structure shown in FIG. 2 also is applied to a transducer, an inverter, etc. The present disclosure is not limited to this, the protection apparatus of the embodiments of the present disclosure may be considered for use under a scenario of applying the IGBT.

In the embodiments of the present disclosure, the delay processing is performed according to a level of the driving signal of the IGBT, the first signal is outputted according to a signal after the delay processing and the driving signal, and the second signal is outputted according to the V_{CE} of the IGBT and the preset threshold value, the alarm signal or the protection signal is outputted in a case where both the first signal and the second signal are valid, the delay processing is performed with a simple structure to realize overcurrent protection and/or short circuit protection, the driving signal will not be affected. In addition, the performance of the IGBT is improved and the cost of the protection circuit is reduced, and easy adjustment of the control on the IGBT is improved.

In some embodiments, the collection circuit 101 does not perform the delay processing in a case where the driving signal is a second level for switching off the IGBT or is a second level that is converted from the first level for switching on the IGBT and is used for switching off the IGBT.

Thereby, the delay processing is performed according to the level of the driving signal only in some cases, the delay processing is not performed in other cases, which realizes low delay of IGBT control and further improves easy adjustment of the control on the IGBT.

In some embodiments, the first level for switching on the IGBT is a high level, the second level for switching off the insulated gate bipolar transistor is a low level.

Thereby, the driving signal is collected according to high and low levels of the driving signal, the delay processing is performed in case of a high level and is not performed in case of a low level, which further improves the performance of the IGBT and reduces the cost of the protection circuit, and improves easy adjustment of the control on the IGBT.

In some embodiments, the detection circuit 102 outputs the second signal of the high level in a case where the voltage is greater than the preset threshold value and a bootstrap power supply of the IGBT is normal; the detection circuit 102 outputs the second signal of the low level in a case where the voltage is smaller or equal to the preset threshold value, or the bootstrap power supply of the IGBT is turned off, or the bootstrap power supply of the IGBT is turned on but is abnormal;
the determination circuit 103 determines the first signal is valid in a case where the first signal is a high level, and determines the second signal is valid in a case where the second signal is a high level.

Thereby, the second signal representing a state of the IGBT is outputted with a simple structure, and whether the IGBT is abnormal may be determined with a simple structure.

It's worth noting that the first level and the second level are not limited to this, for example the first level may also be a low level and the second level may be a high level, processing may be performed correspondingly.

In some embodiments, the first level for switching on the IGBT is a low level, the second level for switching off the insulated gate bipolar transistor is a high level.

Thereby, the driving signal is collected according to high and low levels of the driving signal, the delay processing is performed in case of a low level and is not performed in case of a high level, which further improves the performance of the IGBT and reduces the cost of the protection circuit, and improves easy adjustment of the control on the IGBT.

In some embodiments, the detection circuit 102 outputs the second signal of the low level in a case where the voltage is greater than the preset threshold value and a bootstrap power supply of the IGBT is normal; the detection circuit 102 outputs the second signal of the high level in a case where the voltage is smaller or equal to the preset threshold value, or the bootstrap power supply of the IGBT is turned off, or the bootstrap power supply of the IGBT is turned on but is abnormal;
the determination circuit 103 determines the first signal is valid in a case where the first signal is a low level, and determines the second signal is valid in a case where the second signal is a low level.

Thereby, the second signal representing a state of the IGBT is outputted with a simple structure, and whether the IGBT is abnormal may be determined with a simple structure.

For convenience, by taking the first level being a high level and the second level being a low level as an example, the protection apparatus of the embodiments of the present disclosure is exemplified via a circuit.

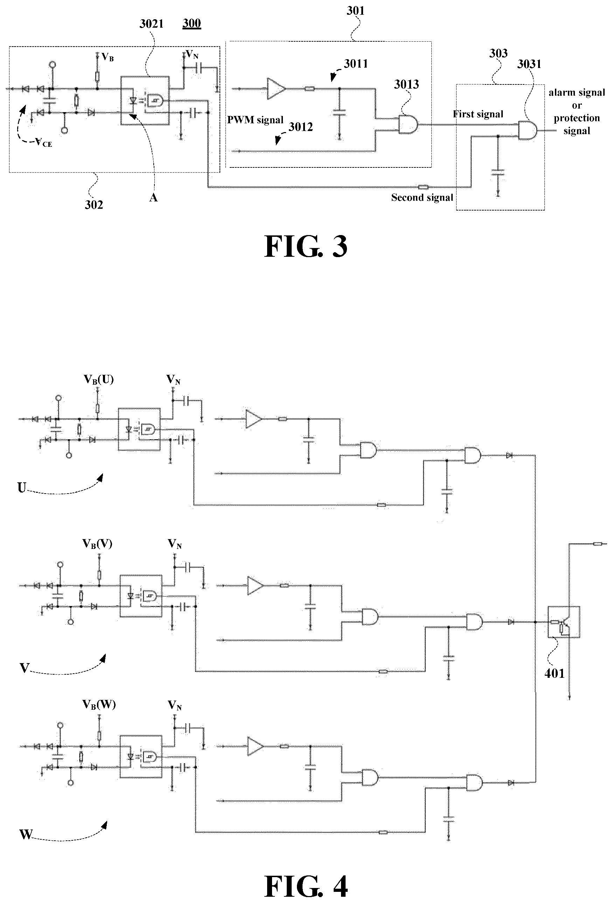

FIG. 3 is an example diagram of the protection apparatus for the IGBT in the embodiments of the present disclosure, as shown in FIG. 3, the protection apparatus 300 includes a collection circuit 301, a detection circuit 302 and a determination circuit 303.

For the collection circuit 301, as shown in FIG. 3, delay processing of the PWM signal is performed by using a branch circuit 3011, and a signal after the delay processing is outputted to an input end of an AND gate 3013; the PWM signal is outputted to another input end of the AND gate 3013 via a branch circuit 3012.

For example, in a case where the PWM signal is a high level (H) or is converted from a low level (L) to a high level (H), the PWM signal is delayed by using an element such as a capacitance of the collection circuit 301; a delay time is determined according to a magnitude of a resistance capacitance, etc., for example the delay time is shorter than a maximum endurance time of the IGBT and is longer than a turn-on time of the IGBT plus a software processing time, etc. By adjusting a value of the element such as the resistance capacitance, a magnitude of a delay can be regulated, thereby easy adjustment is improved.

As shown in FIG. 3, in a case where the PWM signal is a low level (L) or is converted from a high level (H) to a low level (L), AND gate processing is performed on a driving signal originally collected by the branch circuit 3012, delay processing of the branch circuit 3011 is canceled, i.e., delay is not performed. Thereby, time delay is reduced, and the performance of the IGBT is improved.

For the detection circuit 302, as shown in FIG. 3, in a case where the bootstrap power supply of the IGBT (for example, related to the detection power supply V_{B} as shown in FIG. 3) is turned on and works normally and V_{CE} is greater than a preset threshold value (for example, determined according to the detection power supply V_{B}), via the detection circuit 302, a signal is generated at A, an optical coupler 3021 enables the second signal to be a high level; in a case where the V_{CE} is smaller than or equal to the preset threshold value or the bootstrap power supply of the IGBT is turned off or the bootstrap power supply of the IGBT is turned on but is abnormal, via the detection circuit 302, no signal is generated at A, the optical coupler 3021 enables the second signal to be a low level.

For the determination circuit 303, as shown in FIG. 3, the first signal is outputted to an input end of an AND gate 3031; the second signal is outputted to another input end of the AND gate 3031.

For example, in a case where the first signal is a high level, the first signal is valid; in a case where the second signal is a high level, the second signal is valid. When both the first signal and the second signal are a high level, the determination circuit 303 outputs the high level and determines the IGBT is abnormal, the high level is outputted as an alarm signal or protection signal; and when the first signal and/or the second signal are/is a low level, the determination circuit 303 outputs the low level and determines the IGBT is normal.

FIG. 3 only illustrates the embodiments of the present disclosure, but the present disclosure is not limited to this, a specific element or component may be adjusted based on an actual need. For example, the collection circuit 301 illustrates the first signal by only taking the AND gate 3013 as an example, but the present disclosure is not limited to this, for example other element or component may be adopted to realize an identical or similar function.

In some embodiments, a driving power supply (such as the power supply V_{N} as shown in FIG. 3) of the IGBT is different from a detection power supply (such as the power supply V_{B} as shown in FIG. 3) of the protection apparatus and is isolated according to safety regulations. For example, as shown in FIG. 3, V_{B} and V_{N} are configured respectively and are isolated to each other according to safety regulations.

Thereby, a power supply is independently configured for the IGBT and the protection circuit, flexibility in product type selection is improved.

In some embodiments, the IGBT is configured in an IPM; the IPM includes one or more IGBTs configured with the protection apparatus respectively.

Thereby, the protection circuit(s) is/are independently configured for one or more IGBTs, flexibility in product type selection is improved.

In some embodiments, the IPM includes an upper bridge circuit, including three IGBTs, and the three IGBTs are respectively configured with the protection apparatus; the three IGBTs respectively have different bootstrap power supplies, driving power supplies of the three IGBTs are different from the detection power supply of the protection apparatus and are isolated according to safety regulations.

FIG. 4 is another example diagram of a protection apparatus for the IGBT in the embodiments of the present disclosure, as shown in FIG. 4, the protection apparatuses are configured respectively for three U, V, W phases. And four power supplies, i.e., a driving power supply (V_{N} as shown in FIG. 4) of the three IGBTs corresponding to three U, V, W phases and the detection power supplies (V_{B}(U), V_{B}(V), V_{B}(W) as shown in FIG. 4) of the protection apparatus, are respectively configured and are isolated to each other according to safety regulations.

As shown in FIG. 4, output signals of the protection apparatus configured for three U, V, W phases respectively are inputted to a triode 401. Via the triode 401, overcurrent protection and/or short circuit protection of three IGBTs in the upper bridge circuit may be determined comprehensively, an alarm signal or a protection signal is outputted in a case where any IGBT outputs a signal (for example, representing a valid high level), thereby the reliability of the circuit protection is further improved.

Thereby, not only the protection circuit is independently configured for the upper bridge circuit, flexibility in product type selection is improved; but also the detection power supply of the protection circuit and the driving power supplies of three IGBTs of the upper bridge circuit are isolated respectively according to safety regulations and are not affected by common grounding of three driving signals, which further increases reliability.

It's worth noting that the above FIG. 1 to FIG. 4 are only schematic description of the embodiments of the present disclosure, but the present disclosure is not limited to this; for example, other components or devices may be further provided, see relevant technologies for details, description is omitted here. For a component or element which is not specially indicated in FIG. 1 to FIG. 4, relevant technologies may be referred to, the present disclosure does not make limitations.

In addition, the above content is only a schematic description of each device or component, but the present disclosure is not limited to this, and for a specific content of each device or component, relevant technologies may be referred to; moreover, a device or component which is not shown in FIG. 1 to FIG. 4 may be added, or one or more devices or components in FIG. 1 to FIG. 4 may be reduced.

As can be known from the above embodiments, the delay processing is performed according to a level of the driving signal of the IGBT, the first signal is outputted according to a signal after the delay processing and the driving signal, and the second signal is outputted according to the V_{CE} of the IGBT and the preset threshold value, the alarm signal or the protection signal is outputted in a case where both the first signal and the second signal are valid, the delay processing is performed with a simple structure to realize overcurrent protection and/or short circuit protection, the driving signal will not be affected. In addition, the performance of the IGBT is improved and the cost of the protection circuit is reduced, and easy adjustment of the control on the IGBT is improved.

### EMBODIMENTS OF THE SECOND ASPECT

The embodiments of the present disclosure further provide a protection method for the IGBT, the contents same as the embodiments of the first aspect are not repeated.

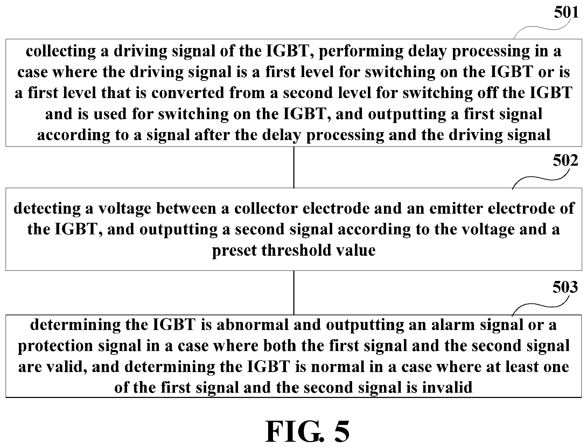

FIG. 5 is a schematic diagram of a protection method for the IGBT in the embodiments of the present disclosure, as shown in FIG. 5, the method includes:
Step 501, collecting a driving signal of the IGBT, performing delay processing in a case where the driving signal is a first level for switching on the IGBT or is a first level that is converted from a second level for switching off the IGBT and is used for switching on the IGBT, and outputting a first signal according to a signal after the delay processing and the driving signal;
Step 502, detecting a voltage between a collector electrode and an emitter electrode of the IGBT, and outputting a second signal according to the voltage and a preset threshold value; and
Step 503, determining the IGBT is abnormal and outputting an alarm signal or a protection signal in a case where both the first signal and the second signal are valid, and determining the IGBT is normal in a case where at least one of the first signal and the second signal is invalid.

It's worth noting that the above FIG. 5 is only schematic description of the embodiments of the present disclosure, but the present disclosure is not limited to this. For example, an execution sequence of each step may be adjusted appropriately, moreover other some steps may be increased or reduced. Persons skilled in the art may make appropriate modifications according to the above contents, not limited to the records in the above FIG. 5.

The embodiments of the present disclosure further provide an IPM, the contents same as the embodiments of the first aspect are not repeated.

The IPM in the embodiments of the present disclosure includes one or more IGBTs, and further includes the protection apparatus 100 according to the embodiments of the first aspect, for example one or more protection apparatuses 100 in the embodiments of the first aspect is/are integrated into the IPM.

In some embodiments, the IPM includes an upper bridge circuit, including three IGBTs, and the three IGBTs are respectively configured with the protection apparatus; the three IGBTs respectively have different bootstrap power supplies, driving power supplies of the three IGBTs are different from the detection power supply of the protection apparatus and are isolated according to safety regulations.

In some embodiments, an output signal of the protection apparatus configured for three IGBTs respectively in the upper bridge circuit is inputted to a triode. Via the triode, overcurrent protection and/or short circuit protection of three IGBTs in the upper bridge circuit is/are determined comprehensively, an alarm signal or a protection signal is outputted in a case where any IGBT outputs a signal (for example, representing a valid high level), thereby the reliability of the circuit protection is further improved.

The present disclosure is described by combining with the specific implementations, however persons skilled in the art should clearly know that these descriptions are exemplary and do not limit the protection scope of the present disclosure. Persons skilled in the art can make various variations and modifications to the present disclosure based on the spirit and principle of the present disclosure, these variations and modifications are also within the scope of the present disclosure.

The preferred implementations of the present disclosure are described with reference to the figures. Many features and advantages of these implementations are clear according to the detailed description; thus, the attached claims aim to cover all these features and advantages of these implementations falling into the true spirit and scope. In addition, persons skilled in the art can easily conceive many modifications and variations, thus it is not intended to limit the implementations of the present disclosure to the exemplified and described precise structures and operations, but all suitable modifications, variations and equivalents falling into their scopes can be covered.

## Claims

1. A protection apparatus for an insulated gate bipolar transistor, **characterized in that** the protection apparatus comprises:
a collection circuit, configured to collect a driving signal of an insulated gate bipolar transistor, perform delay processing in a case where the driving signal is a first level for switching on the insulated gate bipolar transistor or is a first level that is converted from a second level for switching off the insulated gate bipolar transistor and is used for switching on the insulated gate bipolar transistor, and output a first signal according to a signal after the delay processing and the driving signal;
a detection circuit, configured to detect a voltage between a collector electrode and an emitter electrode of the insulated gate bipolar transistor, and output a second signal according to the voltage and a preset threshold value; and
a determination circuit, configured to determine the insulated gate bipolar transistor is abnormal and output an alarm signal or a protection signal in a case where both the first signal and the second signal are valid, and determine the insulated gate bipolar transistor is normal in a case where at least one of the first signal and the second signal is invalid.

2. The protection apparatus according to claim 1, wherein the collection circuit is configured to not perform the delay processing in a case where the driving signal is a second level for switching off the insulated gate bipolar transistor or is a second level that is converted from the first level for switching on the insulated gate bipolar transistor and is used for switching off the insulated gate bipolar transistor.

3. The protection apparatus according to claim 1, wherein the first level for switching on the insulated gate bipolar transistor is a high level, the second level for switching off the insulated gate bipolar transistor is a low level.

4. The protection apparatus according to claim 3, wherein the detection circuit is configured to output the second signal of the high level in a case where the voltage is greater than the preset threshold value and a bootstrap power supply of the insulated gate bipolar transistor is normal; the detection circuit is configured to output the second signal of the low level in a case where the voltage is smaller or equal to the preset threshold value, or the bootstrap power supply of the insulated gate bipolar transistor is turned off, or the bootstrap power supply of the insulated gate bipolar transistor is turned on but is abnormal;
the determination circuit is configured to determine the first signal is valid in a case where the first signal is a high level, and determine the second signal is valid in a case where the second signal is a high level.

5. The protection apparatus according to claim 1, wherein the first level for switching on the insulated gate bipolar transistor is a low level, the second level for switching off the insulated gate bipolar transistor is a high level.

6. The protection apparatus according to claim 5, wherein the detection circuit is configured to output the second signal of the low level in a case where the voltage is greater than the preset threshold value and a bootstrap power supply of the insulated gate bipolar transistor is normal; the detection circuit is configured to output the second signal of the high level in a case where the voltage is smaller or equal to the preset threshold value, or the bootstrap power supply of the insulated gate bipolar transistor is turned off, or the bootstrap power supply of the insulated gate bipolar transistor is turned on but is abnormal;
the determination circuit is configured to determine the first signal is valid in a case where the first signal is a low level, and determine the second signal is valid in a case where the second signal is a low level.

7. The protection apparatus according to claim 1, wherein a driving power supply of the insulated gate bipolar transistor is different from a detection power supply of the protection apparatus and is isolated according to safety regulations.

8. The protection apparatus according to any one of claims 1 to 7, wherein the insulated gate bipolar transistor is configured in an intelligent power module, the intelligent power module comprises one or more insulated gate bipolar transistors, the one or more insulated gate bipolar transistors is/are respectively configured with the protection apparatus.

9. The protection apparatus according to claim 8, wherein the intelligent power module comprises an upper bridge circuit, comprising three insulated gate bipolar transistors, and the three insulated gate bipolar transistors are respectively configured with the protection apparatus;
the three insulated gate bipolar transistors respectively have different bootstrap power supplies, driving power supplies of the three insulated gate bipolar transistors are different from the detection power supply of the protection apparatus and are isolated according to safety regulations.

10. A protection method for an insulated gate bipolar transistor, **characterized in that** the protection method comprises:
collecting a driving signal of an insulated gate bipolar transistor, performing delay processing in a case where the driving signal is a first level for switching on the insulated gate bipolar transistor or is a first level that is converted from a second level for switching off the insulated gate bipolar transistor and is used for switching on the insulated gate bipolar transistor, and outputting a first signal according to a signal after the delay processing and the driving signal;
detecting a voltage between a collector electrode and an emitter electrode of the insulated gate bipolar transistor, and outputting a second signal according to the voltage and a preset threshold value; and
determining the insulated gate bipolar transistor is abnormal and outputs an alarm signal or a protection signal in a case where both the first signal and the second signal are valid, and determining the insulated gate bipolar transistor is normal in a case where at least one of the first signal and the second signal is invalid.
